# FASCICULE DE BREVET EUROPEEN

(11) **EP 2 354 083 B1**
(45) Date de publication et mention de la délivrance du brevet: **30.03.2016**
(21) Numéro de dépôt: 11152700.8
(22) Date de dépôt: 31.01.2011
(51) Int. Cl.: B81B 7/00

(54) **Procédé d'encapsulation d'un microcomposant par un capot renforce mécaniquement**
Verpackungsverfahren für mikromechanisches Bauteil mit mechanisch verstärkter Kappe
Micromechanical device encapsulation process with a mechanically reinforced package cap

(30) Priorité: 04.02.2010 FR 1050781
(43) Date de publication de la demande: 10.08.2011
(73) Titulaire: Commissariat à l'Énergie Atomique et aux Énergies Alternatives, 75015 Paris (FR)
(72) Inventeur: Pornin, Jean-Louis, 38920 Crolles (FR); Gillot, Charlotte, 38120 SAINT EGREVE (FR)
(74) Mandataire: Ilgart, Jean-Christophe

(56) Documents cités:
- US-A1- 2004 173 886
- US-A1- 2006 134 825
- US-B1- 7 595 209

## Description

### DOMAINE TECHNIQUE

L'invention concerne le domaine de l'encapsulation de microcomposants. Le terme « microcomposant » désigne ici tout microsystème de type MEMS (microsystème électromécanique), NEMS (nanosystème électromécanique), MOEMS (microsystème opto-électromécanique), biopuces, ainsi que tout type de composant électronique, optique, ou optoélectronique.

### ÉTAT DE LA TECHNIQUE ANTÉRIEURE

L'encapsulation d'un microcomposant consiste à enfermer le microcomposant dans une cavité délimitée par un capot et par le substrat sur lequel le microcomposant est réalisé. Cette cavité est généralement fermée hermétiquement. Cette encapsulation permet de protéger mécaniquement le microcomposant, par exemple lors de la mise en oeuvre d'étapes telles que la découpe du substrat ou le surmoulage (mise en boîtier du microcomposant). Cette encapsulation permet également de contrôler l'atmosphère régnant à l'intérieur de la cavité en y introduisant par exemple un gaz neutre qui évitera toute réaction chimique avec le microcomposant, ou en faisant le vide dans la cavité.

Une première solution pour encapsuler des microcomposants consiste à réaliser un report de capots, usinés par exemple dans une plaque de silicium, sur le substrat comportant les microcomposants. Ces capots sont soit collés, soit brasés à l'échelle du substrat. Les microcomposants ainsi encapsulés sont ensuite séparés les uns des autres par une découpe du substrat et puis assemblés sur des circuits électroniques.

Ce type d'encapsulation par report de capots présente toutefois plusieurs inconvénients : perte de surface sur le substrat due à la zone de collage/soudure nécessaire pour solidariser les capots au substrat, complexité du procédé de report mis en oeuvre, etc.

Une solution alternative au report de capots consiste à réaliser un packaging couche mince (PCM) des microcomposants. Dans cette solution, le microcomposant est tout d'abord recouvert par un matériau sacrificiel qui est gravé afin de former une portion de matériau sacrificiel dont le volume correspond à celui de la cavité dans laquelle le microcomposant est destiné à être encapsulé. On réalise ensuite un dépôt d'une couche mince sur le matériau sacrificiel. Le matériau sacrificiel est ensuite gravé, par exemple via une ouverture formée à travers la couche mince, formant ainsi une cavité dans laquelle le microcomposant est encapsulé et qui est délimitée notamment par le capot, c'est-à-dire la couche mince.

La réalisation d'un PCM est parfaitement adaptée à l'encapsulation de capteurs de type MEMS et permet de protéger les parties sensibles de ces capteurs des agressions mécaniques liées aux étapes ultérieures de découpe, de manipulation, etc.

Le PCM n'est par contre pas adapté à la mise en oeuvre ultérieure d'une étape de surmoulage qui implique des contraintes thermomécaniques de l'ordre de 100 bars et de 200°C pendant quelques dizaines de secondes, voir quelques minutes, aux microcomposants ainsi encapsulés. Or, cette étape de surmoulage est très importante dans la fabrication des microcomposants car elle permet de fournir un produit fini, protégé de l'environnement et prêt à être intégré par des moyens automatiques à grand débit sur les circuits imprimés par exemple.

Le document FR 2 901 264 A1 décrit la réalisation d'un capot comportant une membrane renforcée par des moyens de renfort mécanique réalisés en structurant une paroi sommitale de la membrane, le capot définissant la cavité dans laquelle le microcomposant est encapsulé.

Un tel renfort mécanique du capot n'est toutefois pas suffisant pour que celui-ci puisse supporter des pressions supérieures ou égales à environ 100 bars qui correspondent aux pressions rencontrées lors de la mise en oeuvre d'une étape de surmoulage du microcomposant encapsulé.

Le document WO 2004/077523 A2 décrit la possibilité de renforcer mécaniquement le capot par un ou plusieurs dépôts de matériaux très durs par pulvérisation sous vide, formant des couches pleine plaque de plusieurs micromètres d'épaisseur recouvrant l'ensemble du substrat, ces couches devant être ensuite gravées pour former des surcouches de renfort mécanique recouvrant le capot.

La mise en oeuvre d'un tel procédé révèle toutefois plusieurs inconvénients: risques de craquèlement du capot dû au stress (c'est à dire des contraintes) induit par les dépôts de matériaux de renforcement mécanique sur de grandes surfaces, déformation du substrat sur lequel est formé le microcomposant, etc. De plus, la gravure des couches réalisée est problématique car le type de matériaux pouvant être utilisé est limité aux matériaux pouvant subir une telle gravure. Enfin, le temps de mise en oeuvre d'une telle gravure peut être important.

### EXPOSÉ DE L'INVENTION

Un but de la présente invention est de proposer un procédé d'encapsulation de microcomposant ne présentant pas les inconvénients des procédé d'encapsulation de l'art antérieur, c'est-à-dire permettant de former une structure d'encapsulation d'un microcomposant apte à subir les contraintes thermomécaniques des étapes de traitement ultérieures à l'encapsulation du microcomposant, par exemple les étapes de surmoulage et de découpe, ces contraintes correspondant par exemple à des pressions supérieures ou égales à environ 100 bars et des températures supérieures ou égales à environ 200°C, et qui ne présente pas les inconvénients liés aux dépôts pleine plaque de couches de matériaux très durs sur la structure d'encapsulation.

Pour cela, la présente invention propose un procédé d'encapsulation d'un microcomposant disposé sur et/ou dans un substrat, comportant au moins les étapes de :
- dépôt d'au moins un matériau sacrificiel recouvrant le microcomposant,
- réalisation d'un capot recouvrant le matériau sacrificiel,
- suppression du matériau sacrificiel via au moins une ouverture réalisée à travers le capot, formant une cavité dans laquelle le microcomposant est disposé,
- dépôt, au moins sur le capot, d'au moins une couche de matériau de bouchage apte à boucher l'ouverture,
- dépôt localisé sans gravure d'au moins une portion de
   matériau de renfort mécanique du capot, recouvrant au moins le capot.

Le terme « dépôt localisé » désigne un dépôt tel que le matériau servant à renforcer mécaniquement le capot soit déposé uniquement à l'emplacement ou aux emplacements souhaités pour réaliser un renfort mécanique du capot, et qui donc ne nécessite pas la mise en oeuvre ultérieure d'une gravure pour supprimer des portions du matériau de renfort mécanique ainsi déposé.

Un tel procédé d'encapsulation permet, par rapport à un procédé d'encapsulation classique de type PCM, de renforcer mécaniquement le capot en déposant localement au moins une portion de matériau de renfort mécanique pouvant être de type polymère ou métallique, par exemple une résine époxy ou du cuivre.

Un tel dépôt localisé de la portion de matériau de renfort mécanique présente l'avantage, par rapport à un dépôt pleine plaque, de réduire le stress (c'est-à-dire les contraintes) induit par le dépôt du matériau de renfort mécanique et de ne pas déformer le substrat et/ou le capot sous la pression due aux contraintes du matériau de renfort mécanique comme c'est le cas pour des couches déposées pleine plaque sur l'ensemble du substrat. De plus, compte tenu du fait que la portion de matériau de renfort mécanique est formée par un dépôt localisé, ce procédé d'encapsulation ne nécessite donc pas la mise en oeuvre d'étape ultérieure de gravure, supprimant ainsi les problèmes liés au temps nécessaire pour réaliser de telles étapes de gravure et permettant l'utilisation de matériaux difficilement gravables ou non gravables.

Quelle que soit la technique de dépôt localisé mise en oeuvre (par exemple une croissance électrolytique, une sérigraphie ou un dépôt à la seringue), il est possible de réaliser une portion de matériau de renfort mécanique d'épaisseur importante, par exemple de plusieurs dizaines de micromètres, et cela sans engendrer de déformation du capot.

De plus, les techniques de dépôt localisé mises en oeuvre dans un tel procédé d'encapsulation peuvent être mises en oeuvre par des moyens classiques de la microélectronique, et permettent donc au procédé d'être rapidement mis en oeuvre sans engendrer de coûts supplémentaires.

La couche de bouchage peut être formée d'une seule couche ou plusieurs couches. De plus, la ou les couche de bouchages peuvent également avoir une fonction de couche d'adhérence et/ou de couche de préparation au dépôt localisé du matériau de renfort mécanique (par exemple permettant de réaliser une croissance électrolytique du matériau de renfort mécanique).

Le dépôt localisé peut être choisi parmi une croissance électrolytique lorsque le matériau de renfort mécanique est un matériau métallique, ou une sérigraphie ou un dépôt à la seringue lorsque le matériau de renfort mécanique est un polymère ou une pâte à braser. Le dépôt localisé correspond dans ce cas à la mise en oeuvre de l'une de ces techniques de dépôt.

Le terme « matériau métallique » désigne un métal ou un alliage métallique électriquement conducteur apte à être obtenu par croissance électrolytique, et ne désigne donc pas des composés tels que des oxydes ou des nitrures de métaux.

Le matériau de renfort mécanique peut avoir un module d'Young inférieur à environ 150 GPa. Un tel matériau de renfort mécanique peut être du cuivre dont le module d'Young est compris entre environ 110 GPa et 120 GPa. De tels matériaux n'engendrent aucune dégradation des éléments sur lesquels la portion de matériau de renfort mécanique est déposée. La portion de matériau de renfort mécanique peut être notamment réalisée sous la forme d'une monocouche. De plus, le matériau de renfort mécanique utilisé peut être choisi suffisamment rigide à la température de mise en oeuvre d'un surmoulage ultérieur pour ne pas avoir à déposer une épaisseur trop importante de matériau de renfort mécanique. Le matériau de renfort mécanique, par exemple une résine époxy, peut présenter une température de transition vitreuse supérieure à la température de surmoulage. Le matériau de renfort mécanique peut comprendre du cuivre (module d'Young égal à environ 110 GPa) et/ou de l'or (module d'Young égal à environ 75 GPa) et/ou du nickel et/ou une résine époxy de type polymère et/ou une pâte à braser.

La perte de surface sur le substrat et/ou la couche de matériau de bouchage pour l'appui de la portion de matériau de renfort mécanique, engendrée en réalisant la portion de matériau de renfort mécanique par un dépôt localisé, est faible, par exemple inférieure ou de l'ordre de l'épaisseur déposée du matériau de renfort mécanique. Ainsi, la portion de matériau de renfort mécanique peut également être déposée sur une zone du substrat et/ou de la couche de matériau de bouchage, ladite zone pouvant être périphérique au capot, telle qu'une distance maximale entre une limite extérieure de ladite zone et le capot puisse être comprise entre environ 5 µm et 100 µm. Ainsi, une telle zone d'appui de la portion de matériau de renfort mécanique de dimensions limitées permet de limiter la surface perdue autour de la cavité.

L'épaisseur de la portion de matériau de renfort mécanique peut être comprise entre environ 10 µm et 50 µm, ou entre environ 15 µm et 30 µm, lorsque le matériau de renfort mécanique est un matériau métallique, ou comprise entre environ 20 µm et 50 µm lorsque le matériau de renfort mécanique est un polymère. De telles épaisseurs sont compatibles avec la miniaturisation des composants microélectroniques qui passe par la réalisation d'un amincissement : le dépôt localisé de la portion de matériau de renfort mécanique peut rester ainsi dans la limite de la hauteur prise pour le câblage du microcomposant, à savoir environ 50 µm.

Le procédé d'encapsulation peut comporter en outre, entre l'étape de dépôt de la couche de matériau de bouchage et l'étape de dépôt localisé, une étape de délimitation d'une zone d'au moins la couche de matériau de bouchage, par exemple une zone de la couche de matériau de bouchage et éventuellement du substrat, de motif similaire à un motif de la portion de matériau de renfort mécanique.

Une telle délimitation peut être obtenue :
- soit par l'utilisation d'un masque, par exemple à base de résine, formé sur la couche de bouchage et éventuellement le substrat, et présentant une ou plusieurs ouvertures correspondant aux zones où la portion de matériau de renfort mécanique doit être formée, le masque pouvant être éliminé après le dépôt localisé de la portion de matériau de renfort mécanique,
- soit par l'utilisation d'une couche d'adhérence électriquement conductrice et d'une couche de matériau, par exemple un matériau métallique, permettant la croissance électrolytique du matériau de renfort mécanique, cette couche pouvant comporter un motif similaire à celui de la portion de matériau de renfort mécanique destinée à être réalisée sur cette zone,
- soit par l'utilisation d'une couche d'adhérence électriquement conductrice et d'une couche de matériau, par exemple un matériau métallique, permettant la croissance électrolytique du matériau de renfort mécanique, cette couche métallique étant ou non gravée, et d'un masque, par exemple à base de résine, formé sur la couche métallique et comprenant une ou plusieurs ouvertures dont les motifs correspondent aux zones où le matériau de renfort mécanique doit être réalisé.

Lorsque le matériau de renfort mécanique est un matériau métallique, l'étape de dépôt localisé peut être obtenue au moins par la mise en oeuvre des étapes suivantes :
- dépôt d'une première couche à base d'au moins un matériau apte à former une couche d'adhérence (également appelée couche d'accroche ou « seed layer » en anglais, servant de couche d'amenée de courant) électriquement conductrice pour la croissance électrolytique du matériau de renfort mécanique, sur le capot et au moins une partie du substrat et/ou de la couche de matériau de bouchage autour du capot,
- dépôt d'une seconde couche à base dudit matériau métallique ou d'un autre matériau compatible avec une croissance électrolytique du matériau de renfort mécanique, sur la première couche,
- gravure de la seconde couche selon un motif similaire à celui de la portion de matériau de renfort mécanique destinée à être réalisée,
- croissance électrolytique du matériau de renfort mécanique sur au moins une portion restante de la seconde couche,
- gravure de la première couche selon un motif similaire à celui de la portion de matériau de renfort mécanique.

La mise en oeuvre d'un dépôt localisé par croissance électrolytique ne nécessite pas d'étape de gravure ultérieure du matériau de renfort ainsi déposé et permet d'obtenir des épaisseurs importantes de matériau, pouvant aller jusqu'à plusieurs dizaines de micromètres pour une couche monolithique.

De plus, un tel procédé n'implique pas l'utilisation d'une résine épaisse pour localiser le matériau déposé.

Dans une variante, lorsque le matériau de renfort mécanique est un matériau métallique, la couche de matériau de bouchage peut être à base d'au moins un matériau apte à former une couche d'adhérence électriquement conductrice pour la croissance électrolytique du matériau de renfort mécanique, l'étape de dépôt localisé pouvant être obtenue au moins par la mise en oeuvre des étapes suivantes :
- dépôt d'une couche à base dudit matériau métallique ou d'un autre matériau compatible avec une croissance électrolytique du matériau de renfort mécanique, sur la couche de matériau de bouchage,
- gravure de la couche à base dudit matériau métallique selon un motif similaire à celui de la portion de matériau de renfort mécanique destinée à être réalisée,
- croissance électrolytique du matériau de renfort mécanique sur au moins une portion restante de la couche à base dudit matériau métallique,
- gravure de la couche de matériau de bouchage selon un motif similaire à celui de la portion de matériau de renfort mécanique.

Dans ce cas, la couche de matériau de bouchage et/ou la couche à base dudit matériau métallique peuvent être obtenues par la mise en oeuvre de dépôts par évaporation sous vide.

Une telle variante permet donc de réaliser une encapsulation, par exemple une encapsulation sous vide, du microcomposant tout en n'utilisant qu'une seule couche pour réaliser à la fois le bouchage de la ou des ouvertures formées dans le capot et la couche d'adhérence électriquement conductrice pour la croissance électrolytique ultérieure du matériau de renfort mécanique. Dans une autre variante, il est également possible que le matériau de bouchage soit également le matériau formant la couche d'adhérence électriquement conductrice pour la croissance électrolytique, mais que son dépôt soit mis en oeuvre par d'autres techniques que l'évaporation sous vide, par exemple par pulvérisation cathodique.

Dans une autre variante, lorsque le matériau de renfort mécanique est un matériau métallique et lorsque la couche de bouchage est à base d'au moins un matériau apte à former une couche d'adhérence électriquement conductrice pour la croissance électrolytique du matériau de renfort mécanique déposée par évaporation sous vide, l'étape de dépôt localisé peut être obtenue au moins par la mise en oeuvre des étapes suivantes :
- dépôt par évaporation sous vide d'une couche à base dudit matériau métallique, sur la couche de matériau de bouchage,
- gravure de la couche à base dudit matériau métallique selon un motif similaire à celui de la portion de matériau de renfort mécanique destinée à être réalisée,
- dépôt d'une couche de résine dont l'épaisseur est sensiblement de l'ordre de grandeur, ou par exemple sensiblement égale, à l'épaisseur de la portion de matériau de renfort mécanique destinée à être réalisée, sur la couche à base dudit matériau métallique et le substrat,
- réalisation d'au moins une ouverture à travers la résine selon un motif correspond à celui de la portion de matériau de renfort mécanique destinée à être réalisée,
- croissance électrolytique du matériau de renfort mécanique sur au moins une portion restante de la couche à base dudit matériau métallique, à travers l'ouverture formée dans la couche de résine,
- retrait de la couche de résine,
- gravure de la couche de matériau de bouchage selon un motif similaire à celui de la portion de matériau de renfort mécanique.

Une telle variante permet d'améliorer la précision de localisation et de réduire l'encombrement de la portion de matériau de renfort mécanique sur le substrat.

Le procédé d'encapsulation peut comporter en outre, lorsque le matériau de renfort mécanique est un polymère, par exemple déposé localement par sérigraphie ou par un dépôt à la seringue, après la réalisation de l'étape de dépôt localisé, la mise en oeuvre d'une étape de recuit de la portion de matériau de renfort mécanique, par exemple à environ 150°C pendant 1 heure lorsque le matériau de renfort mécanique est une résine époxy.

Un dépôt localisé par sérigraphie a notamment pour avantage de pouvoir être mis en oeuvre en une seule étape. De plus, les matériaux choisis pour former la portion de matériau de renfort mécanique peuvent être facilement changés, et notamment être choisis parmi des matériaux peu coûteux (notamment car ces matériaux n'ont pas besoin d'être photosensible ou gravable).

Le procédé d'encapsulation peut comporter en outre la mise en oeuvre de plusieurs étapes de dépôt localisé de matériaux de renfort mécanique telles que la portion de matériau de renfort mécanique soit formée par un empilement de plusieurs couches de matériaux de renfort mécanique.

Le procédé peut également être mis en oeuvre pour réaliser plusieurs structures comportant respectivement plusieurs capots, chaque capot présentant une couche de renfort mécanique.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A à 1E représentent les étapes d'un procédé d'encapsulation d'un microcomposant, objet de la présente invention, selon un premier mode de réalisation,
- les figures 2A à 2D représentent les étapes d'un procédé d'encapsulation d'un microcomposant, objet de la présente invention, selon un second mode de réalisation,
- les figures 3A et 3B représentent les étapes d'un procédé d'encapsulation d'un microcomposant, objet de la présente invention, selon un troisième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

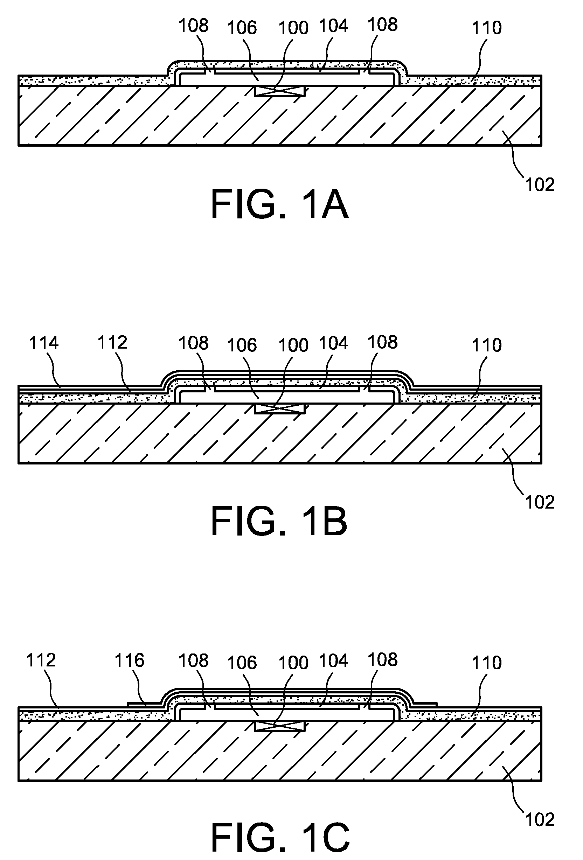

On se réfère tout d'abord aux figures 1A à 1E qui représentent les étapes d'un procédé d'encapsulation d'un microcomposant 100, par exemple de type MEMS, selon un premier mode de réalisation. Ce premier mode de réalisation est particulièrement adapté aux cas où le matériau de renfort mécanique utilisé est métallique.

Comme représenté sur la figure 1A, le microcomposant 100 est préalablement réalisé sur un substrat 102, par exemple à base d'un semi-conducteur tel que du silicium. Un capot 104, dont les bords reposent sur le substrat 102, forme une cavité 106 dans laquelle le microcomposant 100 est encapsulé. Ce capot 104 et cette cavité 106 sont par exemple obtenus en mettant en oeuvre un procédé classique de type PCM. Pour cela, le microcomposant 100 est tout d'abord recouvert d'une couche d'un matériau sacrificiel, par exemple à base de polymère déposé par « spin-on » (dépôt par rotation), qui est ensuite gravée afin qu'une portion restante de la couche de matériau sacrificiel occupe sensiblement le volume de la future cavité 106. Cette portion de matériau sacrificiel est ensuite recouverte d'une couche mince, par exemple à base d'un matériau diélectrique tel que du SiO₂, de SiOₓ ou de SiN, et d'épaisseur comprise entre environ 1 µm et 10 µm, déposée par exemple par CVD (dépôt chimique en phase vapeur), qui est ensuite gravée pour former le capot 104. Le capot 104 est alors percé, formant des ouvertures 108 via lesquelles le matériau sacrificiel est supprimé. Cette suppression du matériau sacrificiel forme alors la cavité 106. Les ouvertures 108 sont enfin bouchées en déposant une couche de matériau de bouchage 110, par exemple d'épaisseur comprise entre environ 1 µm et 10 µm et à base de polymère ou d'un matériau diélectrique déposé par CVD, recouvrant le capot 104 et les portions du substrat 102 se trouvant autour du capot 104.

On forme ensuite des couches de préparation pour réaliser une croissance localisée d'un matériau de renfort mécanique. Pour cela, une couche fine 112, par exemple d'épaisseur égale à environ 100 nm ou comprise entre environ 100 nm et 1 µm, et à base d'un matériau métallique tel que du titane, est déposée sur la couche de bouchage 110. Cette couche 112 est à son tour recouverte d'une fine couche 114, par exemple d'épaisseur égale à environ 100 nm ou comprise entre environ 100 nm et 1 µm, à base de cuivre et/ou de nickel (figure 1B). Ces couches 112 et 114 sont par exemple déposées par pulvérisation cathodique ou par évaporation sous vide. Le matériau de la couche 114, ici du cuivre, correspond au matériau de renfort mécanique qui va être utilisé pour consolider le capot 104. Le matériau de la couche 114 est choisi tel que la couche 114 forme une couche de croissance pour le dépôt localisé ultérieur du matériau de renfort mécanique.

Comme représenté sur la figure 1C, la couche 114 à base de cuivre est gravée afin qu'une portion restante 116 de cette couche 114 délimite un emplacement du matériau de renfort mécanique qui sera déposé par la suite.

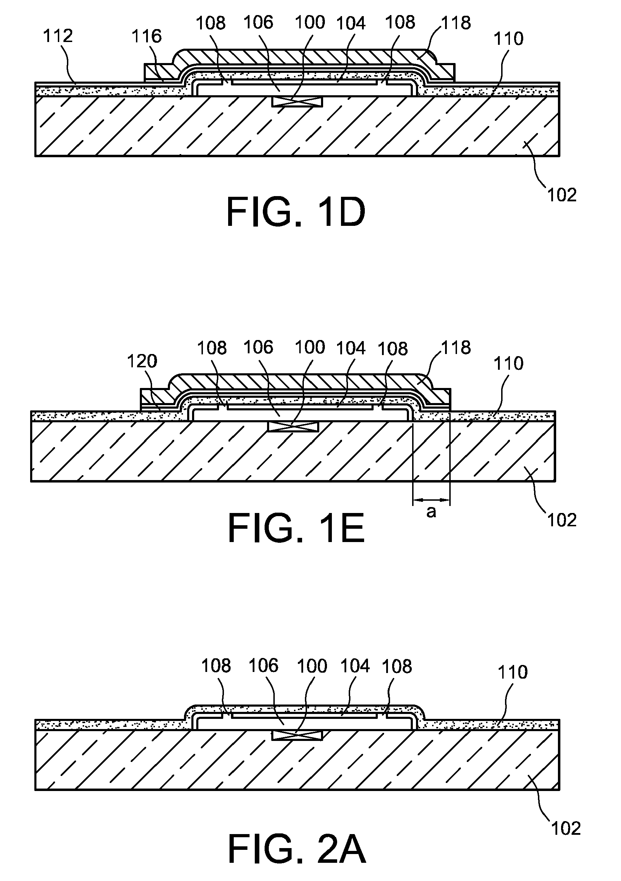

La portion de matériau de renfort mécanique 118, ici du cuivre, est ensuite réalisée par croissance électrolytique sur une épaisseur comprise entre environ 10 µm et 50 µm (figure 1D). Un tel dépôt forme un matériau de renfort mécanique dont le module d'Young est égal à environ 110 GPa. La mise en oeuvre d'un dépôt par croissance électrolytique permet de localiser le dépôt uniquement sur la portion restante 116 de la couche 114 précédemment gravée. On voit donc que le motif de gravure de la couche 114 réalisée à l'étape précédente définit la surface sur laquelle la portion de matériau de renfort mécanique est déposée par la suite. La croissance de la portion de matériau de renfort mécanique 118 a lieu non seulement verticalement, c'est-à-dire perpendiculairement aux plans des couches 112 et 114 (et perpendiculairement à une face principale du substrat 102 sur laquelle est formée le capot 104), mais également horizontalement, c'est-à-dire dans une direction parallèle aux plans des couches 112 et 114, correspondant à une direction parallèle à une face principale du substrat 102 sur laquelle est formée le capot 104. L'épaisseur que l'on fait croître verticalement correspond à la dimension de croissance horizontale. Ainsi, la portion de matériau de renfort mécanique 118 peut dépasser de la portion 116 et se retrouver au-dessus d'une partie du substrat 102 non recouvert par la portion 116.

L'encapsulation du dispositif 100 est achevée en gravant les portions de la couche de croissance 112 non recouvertes par la portion de matériau de renfort mécanique 118 (figure 1E). La portion de matériau de renfort mécanique peut servir de masque lors de cette gravure. Ainsi, une portion restante 120 de la couche de croissance 112 se trouve disposée sous la portion du matériau de renfort mécanique 118.

Si l'on cherche à ce que le microcomposant 100 soit encapsulé sous vide, il est possible de réaliser, à la place du dépôt de la couche de bouchage 110, un dépôt par évaporation sous vide des couches de titane 112 et de cuivre 114 directement sur le capot 104, les ouvertures 108 étant alors bouchées par les couches de titane 112 et de cuivre 114. De plus, il est possible que les ouvertures 108 soient bouchées par les couches de titane 112 et de cuivre 114 sans que les dépôts mis en oeuvre soient des dépôts par évaporation sous vide. Enfin, il est également possible d'omettre la couche de titane 112 et de réaliser uniquement la couche 114 formant une couche d'accroche servant à la croissance de la portion de matériau de renfort mécanique 118, en présence ou non de la couche de bouchage 110.

La surface occupée par la portion de matériau de renfort mécanique 118 autour de la cavité 106 est relativement faible. La dimension « a » représentée sur la figure 1E, qui correspond à l'espace occupé sur le substrat 102 autour de la cavité 106 par la portion de matériau de renfort mécanique 118, peut être par exemple sensiblement égale (ou supérieure lorsque la croissance s'opère également horizontalement) à l'épaisseur déposée de la portion de matériau de renfort mécanique 118.

Dans une variante, la portion de matériau de renfort mécanique 118 peut être obtenue en réalisant plusieurs croissances électrolytiques successives de plusieurs couches de matériaux métalliques qui peuvent être différents les uns des autres. Chacune de ces couches peut avoir une épaisseur égale à environ 10 µm.

On se réfère maintenant aux figures 2A à 2D qui représentent les étapes d'un procédé d'encapsulation du microcomposant 100 selon un second mode de réalisation. Ce second mode de réalisation est particulièrement adapté aux cas où le matériau de renfort mécanique utilisé est un polymère ou une pâte à braser (« solder paste » en anglais), ou crème à braser, comprenant par exemple un alliage métallique tel qu'un alliage à base d'étain.

Comme représenté sur la figure 2A, et de manière analogue à la figure 1A précédemment décrite, le microcomposant 100 est préalablement réalisé sur le substrat 102, et le capot 104, dont les bords reposent sur le substrat 102, forme la cavité 106 dans laquelle le microcomposant 100 est encapsulé. Le capot 104 comporte les ouvertures 108 réalisées pour supprimer le matériau sacrificiel utilisé pour former le capot 104. Ces ouvertures 108 sont bouchées par la couche de matériau de bouchage 110 qui recouvre le capot 104 et les portions du substrat 102 se trouvant autour du capot 104.

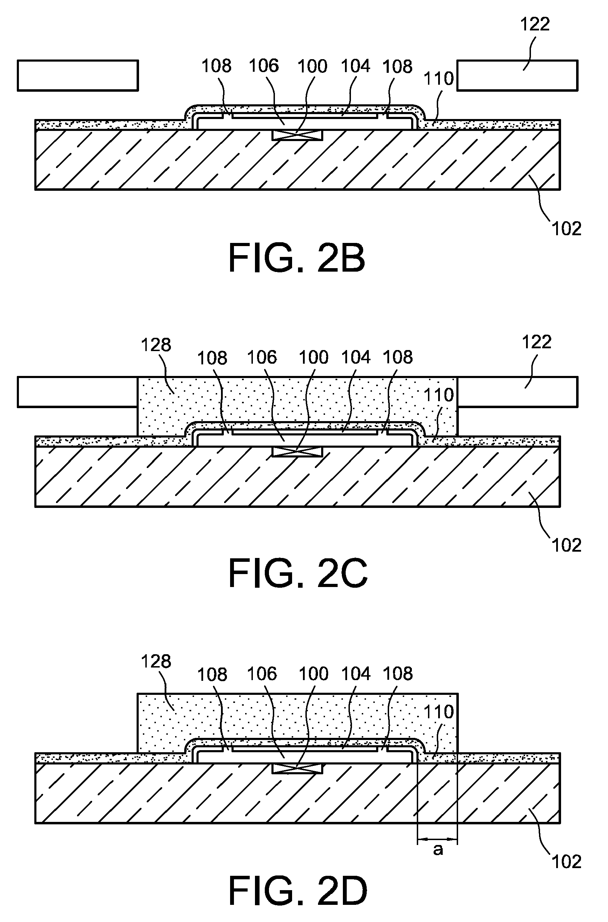

Un masque de sérigraphie 122 est ensuite positionné au-dessus de l'ensemble précédemment réalisé (figure 2B). Le motif du masque 122 correspond au motif de la portion de matériau de renfort mécanique destinée à renforcer le capot 104.

Comme représenté sur la figure 2C, une portion de matériau de renfort mécanique 128, ici à base de polymère, est ensuite déposée à travers le masque de sérigraphie 122. L'épaisseur déposée du matériau de renfort 128 est par exemple de quelques dizaines de micromètres, et par exemple comprise entre environ 10 µm et 50 µm.

Enfin, le masque de sérigraphie 122 est retiré (figure 2D). Un recuit de la portion de matériau de renfort mécanique 128 est ensuite réalisé.

La surface occupée par la portion de matériau de renfort mécanique 128 autour de la cavité 106 est là encore relativement faible. La dimension « a » représentée sur la figure 2D, qui correspond à l'espace occupé sur le substrat 102 autour de la cavité 106 par le matériau de renfort 128, peut être par exemple sensiblement égale à l'épaisseur déposée du matériau de renfort 118, c'est-à-dire par exemple comprise entre environ 10 µm et 50 µm.

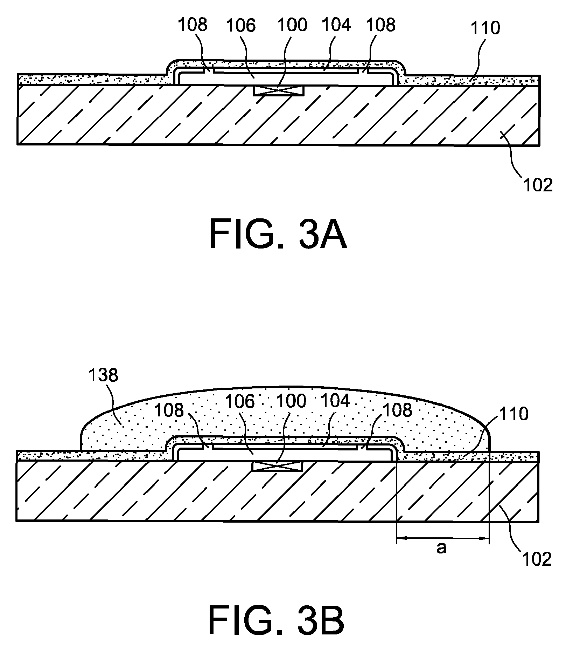

On se réfère maintenant aux figures 3A et 3B qui représentent les étapes d'un procédé d'encapsulation du microcomposant 100 selon un troisième mode de réalisation. Ce troisième mode de réalisation est particulièrement adapté aux cas où le matériau de renfort mécanique utilisé est de type polymère, par exemple sous la forme d'une résine epoxy, ou une pâte à braser (« solder paste » en anglais), ou crème à braser, comprenant par exemple un alliage à base d'étain.

Comme représenté sur la figure 3A, et de manière analogue aux figures 1A et 2A précédemment décrites, le microcomposant 100 est préalablement réalisé sur le substrat 102, et le capot 104, dont les bords reposent sur le substrat 102, forme la cavité 106 dans laquelle le microcomposant 100 est encapsulé. Le capot 104 comporte les ouvertures 108 permettant de supprimer le matériau sacrificiel utilisé pour former le capot 104. Ces ouvertures 108 sont ici bouchées par la couche de matériau de bouchage 110 qui recouvre le capot 104 et les portions du substrat 102 se trouvant autour du capot 104.

Comme représenté sur la figure 3B, une portion de matériau de renfort mécanique 138 est déposée sur le capot 104 et la couche de matériau de bouchage 110 sous la forme d'une goutte calibrée à l'aide d'une seringue et d'une aiguille. Un recuit de la portion de matériau de renfort mécanique 138 est ensuite mis en oeuvre.

La surface occupée par la portion de matériau de renfort mécanique 138 autour de la cavité 106 est là encore relativement faible. La dimension « a » représentée sur la figure 3B, qui correspond à l'espace occupé sur le substrat 102 autour de la cavité 106 par la portion de matériau de renfort mécanique 138, sera par exemple comprise entre environ quelques dizaines de micromètres (20 µm par exemple) et 100 µm. Ce procédé d'encapsulation selon ce troisième mode de réalisation sera plus adapté à une encapsulation de microcomposants comportant une certaine surface disponible autour de la cavité et qui ne nécessite pas un positionnement précis du matériau de renfort.

Le matériau de type polymère utilisé pour réaliser les portion de matériau de renfort mécanique 128 et 138 peut être choisi tel que celui-ci présente un point de transition vitreuse (Tg) supérieur à la température de surmoulage que le microcomposant 100 encapsulé est destiné subir, de façon à ne pas trop se déformer au cours du cycle de polymérisation de la résine de surmoulage. Une épaisseur des matériaux de renfort mécanique 128 et 138 de l'ordre de 50 µm déposés sur le microsystème 100 est bien adaptée à cela. De plus, des matériaux polymères chargés avec une poudre métallique ou minérale peuvent également être utilisés pour former les portions de matériau de renfort mécanique 128 ou 138.

## Revendications

1. Procédé d'encapsulation d'une microcomposant (100) disposé sur et/ou dans un substrat (102), comportant au moins les étapes de :
- dépôt d'au moins un matériau sacrificiel recouvrant le microcomposant (100),
- réalisation d'un capot (104) recouvrant le matériau sacrificiel,
- suppression du matériau sacrificiel via au moins une ouverture (108) réalisée à travers le capot (104), formant une cavité (106) dans laquelle le microcomposant (100) est disposé,
- dépôt, au moins sur le capot (104), d'au moins une couche (110, 112) de matériau de bouchage apte à boucher l'ouverture (108),
- dépôt localisé sans gravure d'au moins une portion de matériau de renfort mécanique (118, 128, 138) du capot (104), recouvrant au moins le capot (104).

2. Procédé d'encapsulation selon la revendication 1, dans lequel le dépôt localisé est choisi parmi une croissance électrolytique lorsque le matériau de renfort mécanique (118) est un matériau métallique, ou une sérigraphie ou un dépôt à la seringue lorsque le matériau de renfort mécanique (128, 138) est un polymère ou une pâte à braser.

3. Procédé d'encapsulation selon l'une des revendications précédentes, dans lequel le matériau de renfort mécanique (118, 128, 138) a un module d'Young inférieur à environ 150 GPa.

4. Procédé d'encapsulation selon l'une des revendications précédentes, dans lequel le matériau de renfort mécanique (118, 128, 138) comprend du cuivre et/ou de l'or et/ou du nickel et/ou une résine époxy de type polymère et/ou une pâte à braser.

5. Procédé d'encapsulation selon l'une des revendications précédentes, dans lequel la portion de matériau de renfort mécanique (118, 128, 138) est également déposée sur une zone du substrat (102) et/ou de la couche (110) de matériau de bouchage, ladite zone étant périphérique au capot (104), telle qu'une distance maximale entre une limite extérieure de ladite zone et le capot (104) soit comprise entre environ 5 µm et 100 µm.

6. Procédé d'encapsulation selon l'une des revendications précédentes, dans lequel l'épaisseur de la portion de matériau de renfort mécanique (118, 128, 138) est comprise entre environ 10 µm et 50 µm lorsque le matériau de renfort mécanique (118) est un matériau métallique, ou comprise entre environ 20 µm et 50 µm lorsque le matériau de renfort mécanique (128, 138) est un polymère.

7. Procédé d'encapsulation selon l'une des revendications précédentes, comportant en outre, entre l'étape de dépôt de la couche (110, 112) de matériau de bouchage et l'étape de dépôt localisé, une étape de délimitation d'une zone d'au moins la couche (110, 112) de matériau de bouchage de motif similaire à un motif de la portion de matériau de renfort mécanique (118, 128, 138).

8. Procédé d'encapsulation selon l'une des revendications précédentes, dans lequel, lorsque le matériau de renfort mécanique (118) est un matériau métallique, l'étape de dépôt localisé est obtenue au moins par la mise en oeuvre des étapes suivantes :
- dépôt d'une première couche (112) à base d'au moins un matériau apte à former une couche d'adhérence électriquement conductrice pour la croissance électrolytique du matériau de renfort mécanique (118), sur le capot (104) et au moins une partie du substrat (102) et/ou de la couche (110) de matériau de bouchage autour du capot (104),
- dépôt d'une seconde couche (114) à base dudit matériau métallique sur la première couche (112),
- gravure de la seconde couche (114) selon un motif similaire à celui de la portion de matériau de renfort mécanique (118) destinée à être réalisée,
- croissance électrolytique du matériau de renfort mécanique (118) sur au moins une portion restante (116) de la seconde couche (114),
- gravure de la première couche (112) selon un motif similaire à celui de la portion de matériau de renfort mécanique (118).

9. Procédé d'encapsulation selon l'une des revendications 1 à 7, dans lequel, lorsque le matériau de renfort mécanique (118) est un matériau métallique, la couche (112) de matériau de bouchage est à base d'au moins un matériau apte à former une couche d'adhérence électriquement conductrice pour la croissance électrolytique du matériau de renfort mécanique (118), l'étape de dépôt localisé étant obtenue au moins par la mise en oeuvre des étapes suivantes :
- dépôt d'une couche (114) à base dudit matériau métallique sur la couche (112) de matériau de bouchage,
- gravure de la couche (114) à base dudit matériau métallique selon un motif similaire à celui de la portion de matériau de renfort mécanique (118) destinée à être réalisée,
- croissance électrolytique du matériau de renfort mécanique (118) sur au moins une portion restante (116) de la couche (114) à base dudit matériau métallique,
- gravure de la couche (112) de matériau de bouchage selon un motif similaire à celui de la portion de matériau de renfort mécanique (118).

10. Procédé d'encapsulation selon l'une des revendications 1 à 7, comportant en outre, lorsque le matériau de renfort mécanique (128, 138) est un polymère, après la réalisation de l'étape de dépôt localisé, la mise en oeuvre d'une étape de recuit de la portion de matériau de renfort mécanique (128, 138).

11. Procédé d'encapsulation selon l'une des revendications précédentes, comportant en outre la mise en oeuvre de plusieurs étapes de dépôt localisé de matériaux de renfort mécanique (118, 128, 138) telles que la portion de matériau de renfort mécanique (118, 128, 138) soit formée par un empilement de plusieurs couches de matériau de renfort mécanique (118, 128, 138).

## Patentansprüche

1. Verfahren zum Einkapseln einer Mikrokomponente (100), die auf und/oder in einem Substrat (102) angeordnet ist, umfassend wenigstens die folgenden Schritte:
- Aufbringen wenigstens eines Opfermaterials, das die Mikrokomponente (100) bedeckt,
- Realisieren eines Deckels (104), der das Opfermaterial bedeckt,
- Entfernen des Opfermaterials durch wenigstens eine Öffnung (108), die durch den Deckel (104) hindurch realisiert ist, zum Bilden eines Hohlraums (106), in dem die Mikrokomponente (100) angeordnet ist,
- Aufbringen, wenigstens auf dem Deckel (104), wenigstens einer Schicht (110, 112) aus Verschlussmaterial, die dazu ausgelegt ist, die Öffnung (108) zu verschließen,
- lokalisiertes Aufbringen, ohne Gravieren, wenigstens eines Bereichs aus Material (118, 128, 138) zur mechanischen Verstärkung des Deckels (104), der wenigstens den Deckel (104) bedeckt.

2. Verfahren zum Einkapseln nach Anspruch 1, bei dem das lokalisierte Aufbringen ausgewählt ist aus einem elektrolytischen Aufwachsen, wenn das Material (118) zur mechanischen Verstärkung ein metallisches Material ist, oder einer Serigraphie, oder einem Aufbringen mit Spritze, wenn das Material (128, 138) zur mechanischen Verstärkung ein Polymer oder eine Lötpaste ist.

3. Verfahren zum Einkapseln nach einem der vorhergehenden Ansprüche, bei dem das Material (118, 128, 138) zur mechanischen Verstärkung ein Young-Modul hat, das kleiner als ungefähr 150 GPa ist.

4. Verfahren zum Einkapseln nach einem der vorhergehenden Ansprüche, bei dem das Material (118, 128, 138) zur mechanischen Verstärkung Kupfer und/oder Gold und/oder Nickel und/oder ein Epoxidharz vom Typ Polymer und/oder eine Lötpaste umfasst.

5. Verfahren zum Einkapseln nach einem der vorhergehenden Ansprüche, bei dem der Bereich von Material (118, 128, 138) zur mechanischen Verstärkung ebenfalls auf einer Zone des Substrats (102) und/oder der Schicht (110) aus Verschlussmaterial aufgebracht wird, welche Zone am Umfang des Deckels (104) liegt, derart, dass ein maximaler Abstand zwischen einer äußeren Grenze der Zone und dem Deckel (104) zwischen ungefähr 5 µm und 100 µm enthalten ist.

6. Verfahren zum Einkapseln nach einem der vorhergehenden Ansprüche, bei dem die Dicke des Bereichs von Material (118, 128, 138) zur mechanischen Verstärkung zwischen ungefähr 10 µm und 50 µm enthalten ist, wenn das Material (118) zur mechanischen Verstärkung ein metallisches Material ist, oder zwischen ungefähr 20 µm und 50 µm enthalten ist, wenn das Material (128, 138) zur mechanischen Verstärkung ein Polymer ist.

7. Verfahren zum Einkapseln nach einem der vorhergehenden Ansprüche, ferner umfassend, zwischen dem Schritt des Aufbringens der Schicht (110, 112) von Verschlussmaterial und dem Schritt des lokalisierten Aufbringens, einen Schritt der Begrenzung einer Zone wenigstens der Schicht (110, 112) aus Verschlussmaterial mit einem Motiv ähnlich einem Motiv des Bereichs von Material (118, 128, 138) zur mechanischen Verstärkung.

8. Verfahren zum Einkapseln nach einem der vorhergehenden Ansprüche, bei dem dann, wenn das Material (118) zur mechanischen Verstärkung ein metallisches Material ist, der Schritt des lokalisierten Aufbringens wenigstens durch Ausführung der folgenden Schritte erzielt wird:
- Aufbringen einer ersten Schicht (112) auf Basis wenigstens eines Materials, das zur Bildung einer elektrisch leitenden Haftschicht für das elektrolytische Aufwachsen des Materials (118) zur mechanischen Verstärkung ausgelegt ist, auf dem Deckel (104) und wenigstens einem Teil des Substrats (102) und/oder der Schicht (110) aus Verschlussmaterial um den Deckel (104) herum,
- Aufbringen einer zweiten Schicht (114) auf Basis des metallischen Materials auf der ersten Schicht (112),
- Gravieren der zweiten Schicht (114) gemäß einem Motiv ähnlich jenem des Bereichs von Material (118) zur mechanischen Verstärkung, der realisiert werden soll,
- elektrolytisches Aufwachsen des Materials (118) zur mechanischen Verstärkung auf wenigstens einem verbleibenden Bereich (116) der zweiten Schicht (114),
- Gravieren der ersten Schicht (112) gemäß einem Motiv ähnlich jenem des Bereichs aus Material (118) zur mechanischen Verstärkung.

9. Verfahren zum Einkapseln nach einem der Ansprüche 1 bis 7, bei dem dann, wenn das Material (118) zur mechanischen Verstärkung ein metallisches Material ist, die Schicht (112) aus Verschlussmaterial auf Basis wenigstens eines Materials ist, das dazu ausgelegt ist, eine elektrisch leitenden Haftschicht für das elektrolytische Aufwachsen des Materials (118) zur mechanischen Verstärkung zu bilden, wobei der Schritt des lokalisierten Aufwachsens wenigstens durch die Durchführung der folgenden Schritte erzielt wird:
- Aufbringen einer Schicht (114) auf Basis des metallischen Materials auf der Schicht (112) aus Verschlussmaterial,
- Gravieren der Schicht (114) auf Basis des metallischen Materials gemäß einem Motiv ähnlich jenem des Bereichs aus Material (118) zur mechanischen Verstärkung, der realisiert werden soll,
- elektrolytisches Aufwachsen des Materials (118) zur mechanischen Verstärkung auf wenigstens einem verbleibenden Bereich (116) der Schicht (114) auf Basis des metallischen Materials,
- Gravieren der Schicht (112) aus Verschlussmaterial gemäß einem Motiv ähnlich jenem des Bereichs aus Material (118) zur mechanischen Verstärkung.

10. Verfahren zum Einkapseln nach einem der Ansprüche 1 bis 7, ferner umfassend dann, wenn das Material (128, 138) zur mechanischen Verstärkung ein Polymer ist, nach der Durchführung des Schritts des lokalisierten Aufbringens die Durchführung eines Schritts zum Tempern des Bereichs aus Material (128, 138) zur mechanischen Verstärkung.

11. Verfahren zum Einkapseln nach einem der vorhergehenden Ansprüche, ferner umfassend die Durchführung von mehreren Schritten zum lokalisierten Aufbringen von Materialien (118, 128, 138) zur mechanischen Verstärkung derart, dass der Bereich aus Material (118, 128, 138) zur mechanischen Verstärkung durch einen Stapel von mehreren Schichten aus Material (118, 128, 138) zur mechanischen Verstärkung gebildet wird.

## Claims

1. Method for encapsulating a micro-component (100) arranged on and/or in a substrate (102), including at least the following steps:
- depositing at least one sacrificial material covering the micro-component (100),
- making a cap (104) covering the sacrificial material,
- removing the sacrificial material via at least one opening (108) formed through the cap (104), forming a cavity (106) in which the micro-component (100) is arranged,
- depositing, at least on the cap (104), at least one layer (110, 112) of plugging material capable of plugging the opening (108),
- localized deposition without etching of at least one portion of mechanically reinforcing material (118, 128, 138) of the cap (104), covering at least the cap (104).

2. Encapsulation method according to claim 1, wherein the localized deposition is chosen among electrolytic growth when the mechanically reinforcing material (118) is a metallic material, or serigraphy or syringe deposition when the mechanically reinforcing material (128, 138) is a polymer or solder paste.

3. Encapsulation method according to one of previous claims, wherein the mechanically reinforcing material (118, 128, 138) has a Young's modulus below about 150 GPa.

4. Encapsulation method according to one of previous claims, wherein the mechanically reinforcing material (118, 128, 138) comprises copper and/or gold and/or nickel and/or an epoxy resin of the polymer type and/or a solder paste.

5. Encapsulation method according to one of previous claims, wherein the portion of mechanically reinforcing material (118, 128, 138) is also deposited on a zone of the substrate (102) and/or of the layer (110) of plugging material, said zone being peripheral to the cap (104), such that a maximum distance between an outer boundary of said zone and the cap (104) is between about 5 µm and 100 µm.

6. Encapsulation method according to one of previous claims, wherein the thickness of the portion of mechanically reinforcing material (118, 128, 138) is between about 10 µm and 50 µm when the mechanically reinforcing material (118) is a metallic material, or between about 20 µm and 50 µm when the mechanically reinforcing material (128, 138) is a polymer.

7. Encapsulation method according to one of previous claims, also including, between the step for depositing the layer (110, 112) of plugging material and the localized deposition step, a step for delimiting a zone of at least the layer (110, 112) of plugging material with a pattern similar to a pattern of the portion of mechanically reinforcing material (118, 128, 138).

8. Encapsulation method according to one of previous claims, wherein, when the mechanically reinforcing material (118) is a metallic material, the localized deposition step is obtained at least by carrying out the following steps:
- depositing a first layer (112) comprising at least one material able to form an electrically conductive adhesion layer for the electrolytic growth of the mechanically reinforcing material (118), on the cap (104) and at least part of the substrate (102) and/or of the layer (110) of plugging material around the cap (104),
- depositing a second layer (114) comprising said metallic material on the first layer (112),
- etching the second layer (114) according to a pattern similar to that of the portion of mechanically reinforcing material (118) intended to be made,
- electrolytic growth of the mechanically reinforcing material (118) on at least one remaining portion (116) of the second layer (114),
- etching the first layer (112) according to a pattern similar to that of the portion of mechanically reinforcing material (118).

9. Encapsulation method according to one of claims 1 to 7, wherein, when the mechanically reinforcing material (118) is a metallic material, the layer (112) of plugging material comprises at least one material able to form an electrically conductive adhesion layer for the electrolytic growth of the mechanically reinforcing material (118), the localized deposition step being obtained at least by carrying out the following steps:
- depositing a layer (114) comprising said metallic material on the layer (112) of plugging material,
- etching the layer (114) comprising said metallic material according to a pattern similar to that of the portion of mechanically reinforcing material (118) intended to be made,
- electrolytic growth of the mechanically reinforcing material (118) on at least one remaining portion (116) of the layer (114) comprising said metallic material,
- etching the layer (112) of plugging material according to a pattern similar to that of the portion of mechanically reinforcing material (118).

10. Encapsulation method according to one of claims 1 to 7, further comprising, when the mechanically reinforcing material (128, 138) is a polymer, after performing the localized deposition step, carrying out a step for annealing the portion of mechanically reinforcing material (128, 138).

11. Encapsulation method according to one of previous claims, also including the implementation of several steps for localized deposition of mechanically reinforcing materials (118, 128, 138) such that the portion of mechanically reinforcing material (118, 128, 138) is formed by a stack of several layers of mechanically reinforcing materials (118, 128, 138).
